# Europäisches Patentamt
# European Patent Office
# Office européen des brevets

(11) Veröffentlichungsnummer: **0 001 302**
**B1**

(12) **EUROPÄISCHE PATENTSCHRIFT**

(45) Veröffentlichungstag der Patentschrift: **15.07.81**

(21) Anmeldenummer: **78200141.6**

(22) Anmeldetag: **16.08.78**

(51) Int. Cl.³: **H 05 K 5/06, H 01 H 13/06, A 61 C 17/00, B 26 B 19/38**

(54) Gehäuse für Geräte zur Körperpflege.

(30) Priorität: **31.08.77 DE 2739137**

(43) Veröffentlichungstag der Anmeldung:
**04.04.79 Patentblatt 79/7**

(45) Bekanntmachung des Hinweises auf die Patenterteilung:
**15.07.81 Patentblatt 81/28**

(84) Benannte Vertragsstaaten:
**BE CH FR GB NL SE**

(56) Entgegenhaltungen:
DE - A - 2 413 016
DE - B - 2 448 627
DE - A - 2 558 962
US - A - 2 207 269
US - A - 3 024 337
US - A - 3 185 001
US - A - 3 959 610
US - A - 3 978 297

(73) Patentinhaber: **Braun Aktiengesellschaft**
**Rüsselsheimer Strasse 22**
**D-6000 Frankfurt/Main (DE)**

(72) Erfinder: **Ullmann, Roland**
**Schubertstrasse 12**
**D-6053 Obertshausen (Hausen) (DE)**
Erfinder: **Zimmermann, Klaus**
**Hintergasse 12**
**D-6201 Bremthal (Taunus) (DE)**

(74) Vertreter: **Einsele, Rolf**
**Braun Aktiengesellschaft Postfach 1120 Am**
**Schanzenfeld**
**D-6242 Kronberg Taunus (DE)**

Courier Press, Leamington Spa, England.

Gehäuse für Geräte zur Körperpflege

Die Erfindung betrifft ein Gehäuse für Geräte zur Körperpflege,insbesondere für von Hand gehaltene und geführte Geräte wie Elektrorasierer, elektrische Zahnbürsten oder dergleichen.

Bekannte Gehäuse für insbesondere elektrisch betriebene Geräte dieser Art sind entweder aus Metall gegossen (Druckguß, Spritzguß) oder aus (tiefgezogenen) Blechteilen hergestellt und dann oftmals mit einer Folie aus Kunststoff beklebt, oder aber sie sind vollständig aus Kunststoff gefertigt, wobei die Außenflächen mit einer eingepreßten Oberflächenstruktur (Riffelung, Aufrauhung) versehen ist.

Aus der US—PS 3,959,610 ist ein Gehäuse bekannt, bei dem die auf die perforierte Gehäusewand abgelegte und partiell mit dieser verbundenen Folie oder Platte aus einem Kunststoff oder aus einem anderen gummiähnlichen Werkstoff gebildet ist, wobei die den Vorsprüngen abgekehrte Seite der Folie mit einer weiteren Folie beschichtet ist, die aus einem elektrisch leitenden Werkstoff besteht. Weiterhin ist ein Werkzeugschaft mit perforierter Schaftwand bekannt (US—PS 3,185,001), auf dessen Innenseite hohle Gummikörper eingelegt sind, die Vorsprünge aufweisen, die sich durch die Perforation der Schaftwand hindurch erstrecken und über die Außenfläche hervorstehen. Aus der DE—AS 25 58 962 ist schließlich ein Gehäuse für einen von Hand gehaltenen Elektrorasierer bekannt, dessen Außenfläche mit noppenförmigen Vorsprüngen versehen ist.

Die bekannten Gehäuse haben erfahrungsgemäß den Nachteil, daß sie die Schweißabsonderung (insbesondere) an den Handflächen des Gerätebenutzers begünstigen. Schweißabsonderungen aber führen rasch zu Korosionserscheinungen am Gehäuse und bewirken ein wenig sympathisches Gefühl beim Gerätebenutzer. Ein Metallgehäuse hat schließlich den Nachteil, daß seine Außenflächen leicht zerkratzen, was das Gerät rasch unansehnlich macht.

Aufgabe der Vorliegenden Erfindung ist es, ein ein- oder mehrteiliges Gehäuse zu schaffen, dessen Oberflächenstruktur oder Oberflächenfinish gegen Zerkratzen widerstandsfähig ist. Das Gehäuse soll schließlich so ausgebildet sein, daß Gehäuse bei vollständiger Gewährleistung aller Funktionen gegen Feuchtigkeit, Spritzwasser und Staub abdichtbar ist.

Erfindungsgemäß wird diese Aufgabe gelöst durch eine auf die Innenseite einer perforierten Gehäusewand eines Gehäuseteils aufgelegte und zumindest paretiell mit dieser fest verbundenen beispielsweise verklebten Folie oder Platte aus einem Kunststoff oder anderem gummiähnlichen Werkstoff, wobei diese Folie oder Platte einseitig mit einer Vielzahl von über eine Fläche der Folie oder der Platte hervorstehenden noppen- oder zungenartigen Vorsprüngen versehen ist, die nach Zahl und Größe so angeordnet sind, daß sie sich durch die Perforationen der Gehäusewand hindurcherstrecken und um ein Geringes über die Außenfläche des Gehäuses hervorstehen.

Ausgestaltungen der Erfindung ergeben sich aus den Unteransprüchen.

Die Erfindung läßt die verschiedensten Ausführungsmöglichkeiten zu. Einige davon sind in den anhängenden Zeichnungen Schematisch dargestellt.
Und zwar zeigen
Fig. 1 den Teilschnitt durch die perforierte Gehäusewand und die mit Noppen versehene Folie,
Fig. 2 den Teilschnitt durch die Gehäusewand und die mit ihr verbundenen Folie, wobei die Folie Noppen unterschiedlicher Länge aufweist,
Fig. 3 den Teilschnitt gemäß Fig. 1, wobei jedoch die Folie partiell in Richtung auf das Gehäuseinnere und eine elektrische Leiterplatte zu verschoben ist und die Verbindung zwischen zwei Leiterbahnen hergestellt und
Fig. 4 den Teilschnitt durch Gehäusewand und Folie, wobei die Gehäusewand partiell eine Vertiefung aufweist (im Maßstab etwa 10:1).

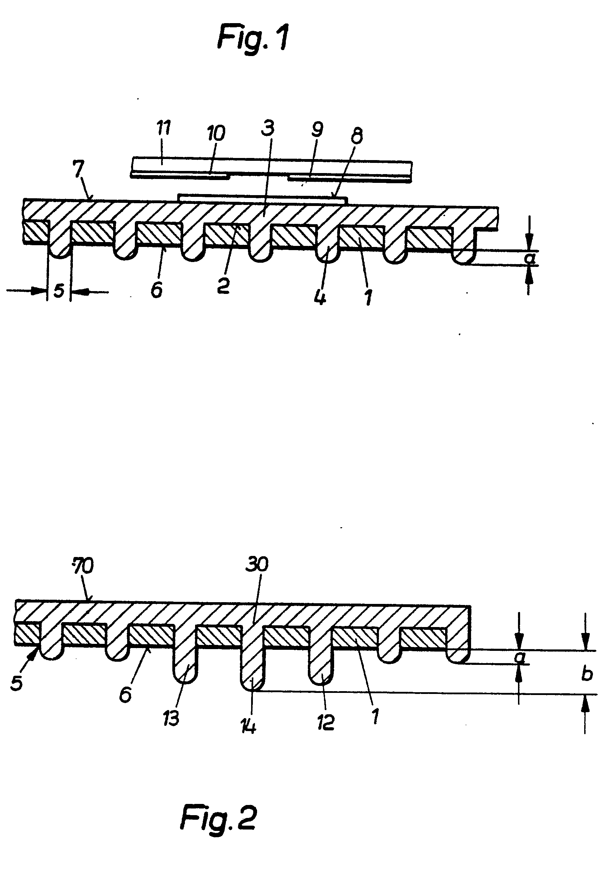

Gemäß Figur 1 ist die Gehäusewand 1 an ihrer Innenseite 2 mit einer Folie 3 beklebt, die eine Vielzahl von sich nach außen zu erstreckenden Noppen 4 aufweist, wobei die Noppen 4 durch Bohrungen oder Perforationen 5 hindurchragen derart, daß sie um ein geringes Maß. a über die Außenfläche 6 der Gehäusewand 1 hervorstehen. Die der Gehäusewand 1 abgekehrte Innenfläche 7 der Folie 3 ist partiell mit einer Metallfolie 8 beschichtet.

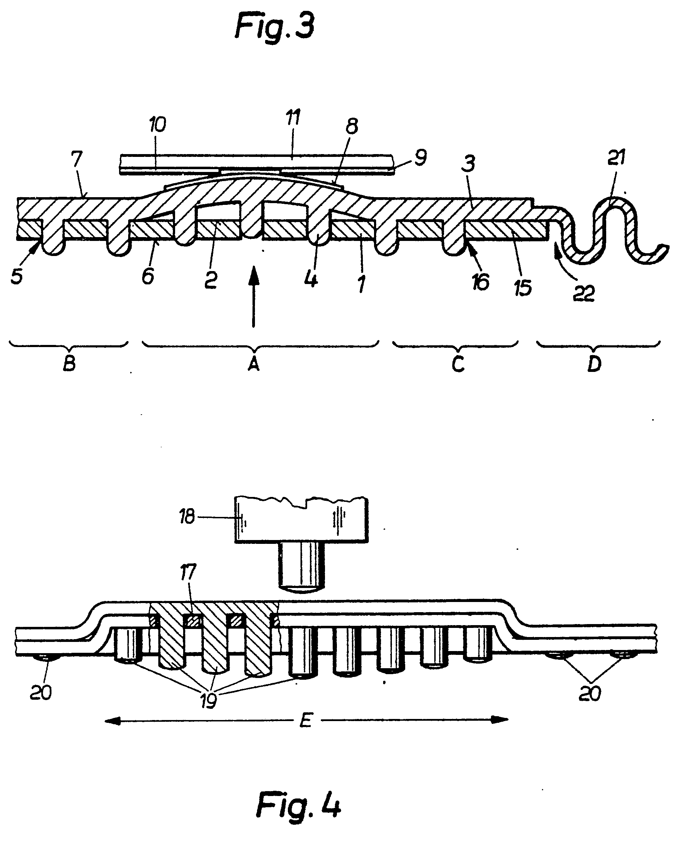

Wie Figur 3 zeigt, läßt sich die Folie 3 durch Berühren derjenigen Noppen 4, die sich im Breich A befinden, in Pfeilrichtung soweit in das Gehäuseinnere verschieben bzw. auswölben, daß die Metallfolie 8 die beiden Leiterbahnen 9, 10 berührt, so daß der elektrische Stromdurchgang hergestellt ist. Während die Folie 3 in den Bereichen B und C fest mit der Gehäusewand 1 verklebt ist, liegt die Folie im Bereich von A an der Gehäusewand 1 infolge ihrer Eigenspannung an der Innenseite 2 der Gehäusewand 1 an.

Während bei der Ausführungsform nach den Figuren 1 und 3 alle Noppen 4 um das Maß a über die Außenfläche 6 hervorragen, sind die Noppen 12 bis 14 gemäß Figur 2 länger ausgebildet und ragen bis auf das Maß b über die Außenfläche 6 der Gehäusewand 1 hervor. Durch eine derartig unterschiedlich lange Ausbildung der Noppen kann erreicht werden, daß die Bereiche z.B. A in denen die Folie auswölbbar ist von außen her lokalisierbar werden.

Wie Figur 3 zeigt, können die Stoßkanten oder Fugen 16 zwischen zwei Gehäuseteilen 1, 15 staub- und spritzwasserdicht zusammengefügt werden, ohne daß diese Fungen oder Spalten zwischen den einzelnen Gehäuseteilen von außen her sichtbar sind.

Wie Figur 4 zeigt, kann die Gehäusewand 17 z.B. im Bereich E eines Schalters oder Taste 18 mit einer Vertiefung versehen sein, wobei die Noppen 19 entsprechend länger ausgeführt sind als die Noppen 20 der Folienpartien, mit denen die übrige Gehäusewand beklebt ist.

*Auflistung und Gezeichnung der Einzelteile des Gehäuses*

1, 15, 17: Gehäusewandteil welches mit einer Vielzahl von über ihre ganze Fläche gleichmäßig verteilt angeordneten Peiforationen versehen ist.

2: Innenseite der Gehäusewand.

3, 30: Folie mit über ihre Außenfläche verteilt angeordneten Noppen.

4, 12, 13, 14, 19, 20: Noppen.

5: Perforationen.

6: Gehäuseaußenfläche.

7, 70: Folieninnenfläche.

8: Metallfolie (Beschichtung).

9, 10: Leiterbahnen.

11: Leiterplatte.

16, 22: Fuge zwischen zwei Gehäuseteilen.

18: elektrischer Schalter.

21: Faltenbalg.

## Patentansprüche

1. Gehäuse für Geräte zur Körperpflege, insbesondere für von Hand gehaltene und geführte Geräte wie Elektrorasierer, elektrische Zahnbürsten oder dergleichen, gekennzeichnet durch eine auf die Innenseite einer perforierten Gehäusewand (1, 15, 17) eines Gehäuseteils aufgelegte und zumindest partiell mit dieser fest verbundenen beispielsweise verklebten Folie (3, 30, 31) oder Platte aus einem Kunststoff oder anderem gummiähnlichen Werkstoff und dadurch daß diese Folie (3, 30, 31) oder Platte einseitig mit einer Vielzahl von über eine Fläche der Folie oder der Platte hervorstehenden noppen- oder zungenartigen Vorsprüngen (4, 12, 13, 14, 19, 20) versehen ist, die nach Zahl und Größe so angeordnet sind, daß sie sich durch die Perforationen (5) der Gehäusewand (1, 15, 17) hindurcherstrecken, und um ein Geringes (a, b) über die Außenfläche (2) des Gehäuses (1, 15, 17) hervorstehen.

2. Gehäuse nach Anspruch 1 dadurch gekennzeichnet, daß die Vorsprünge (4, 19) der Folie (3) oder Platte, die im Bereich eines im Gehäuseinneren angeordneten Schalters (18), einer Taste oder eines Kontakts (8, 9, 10) vorgesehen sind, verschiebbar sind, um ein Auswölben der Folie (3) oder Platte nach innen zu gestatten, wobei die Folie (3) oder Platte außerhalb der Auswölbebereiche (A, E) mit der Gehäusewand (1, 15, 17) fest verbunden ist.

3. Gehäuse nach den Ansprüchen 1 und 2 dadurch gekennzeichnet, daß die Noppen (4, 12, 13, 14, 19, 20) unterschiedlich lang ausgebildet sind.

4. Gehäuse nach den Ansprüchen 1 bis 3 dadurch gekennzeichnet, daß die der noppenbestückten Seite abgekehrte Seite (7) der Folie (3) oder Platte zumindest partiell mit einer Folie (8) beschichtet ist, die aus einem elektrisch leitenden Werkstoff besteht.

5. Gehäuse nach einem der Ansprüche 1 bis 4 dadurch gekennzeichnet, daß die Folie (3) oder Platte vorzugsweise im Bereich von Gehäusetrennfugen (22) unterschiedlich dick und/oder als Faltenbalg (21) ausgebildet ist.

## Revendications

1. Boîtier pour appareils de soins corporels, en particulier pour appareils tenus et guidés à la main tels que des rasoirs électriques, des brosses à dents électriques ou analogues, caractérisé par une feuille ou une plaque (3, 30, 31) en matière plastique ou une autre matière semblable à du caoutchouc, qui est disposée sur le côté intérieur de la paroi perforée (1, 15, 17) d'une piéce formant boîtier et est au moins en partie liée solidement à elle, par collage par exemple, cette feuille ou cette plaque présentant d'un côté une multitude d'aspérités (4, 12, 13, 14, 19, 20) semblables à des boutons ou à des languettes, qui font saillie d'une face de la feuille ou de la plaque et sont disposées et agencées de par leur nombre et leur taille de manière qu'elles traversent les perforations (5) de la paroi de boîtier (1, 15, 17) et dépassent d'une faible distance (a, b) de la surface extérieure (2) du boîtier (1, 15, 17).

2. Boîtier selon la revendication 1, caractérisé en ce que les aspérités (4, 19) de la feuille (3) ou de la plaque prévues dans la région d'un interrupteur (18), d'un poussoir ou d'um contact (8, 9, 10) disposé à l'intérieur du boîtier sont déplaçables afin de permettre le renflement de la feuille (3) ou de la plaque vers l'intérieur, la feuille (3) ou la plaque étant solidement liée à la paroi de boîtier (1, 15, 17) à l'extérieur des zones (A, E) où la feuille peut être repoussée vers l'intérieur du boitier.

3. Boîtier selon les revendications 1 et 2, caractérisé en ce que les boutons (4, 12, 13, 14, 19, 20) ont des longueurs différentes.

4. Boîtier selon les revendications 1 à 3, caractérisé on ce que le côté (7) de la feuille (3) ou de la plaque opposé au côté garni de boutons est au moins en partie revêtu d'une feuille (8) d'une matière électriquement conductrice.

5. Boîtier selon l'une des revendications 1 à 4, caractérisé en ce que la feuille (3) ou la plaque présente une épaisseur différente et/ou est réalisée à la façon d'un soufflet (21), de préférence dans la région de joints (22) entre des parties de boîtier.

## Claims

1. Casing for body care equipment, particularly for hand-held and guided equipment such as electric shavers, electric toothbrushes or the like, characterized by a foil (3, 30, 31) or sheet of a plastics or similar rubber-like material applied to the inside of a perforated casing wall (1, 15, 17) of a casing part and at least partly firmly connected thereto, for example by adhesion and in that this foil (3, 30, 31) or sheet is provided on one side with a plurality of stud or tongue-like projections (4, 12, 13, 19, 20) projecting over one face of the foil or sheet, the number and size of said projections being such that they extend through the perforations (5) of casing wall (1, 15, 17) and project by a small amount (a, b) beyond the outer face (2) of casing (1, 15, 17).

2. Casing according to claim 1, characterized in that the projections (4, 19) of the foil (3) or sheet are displaceable in the vicinity of a switch (18), a key or a contact (8, 9, 10) arranged in the inside of the casing in order to permit an inward bending of the foil (3) or sheet, the foil (3) or sheet being firmly connected to the casing wall (1, 15, 17) outside the bent areas (A, E).

3. Casing according to claims 1 and 2, characterized in that the studs (4, 12, 13, 14, 19, 20) have different lengths.

4. Casing according to claims 1 to 3, characterized in that the side (7) of the foil (3) or sheet remote from the side carrying the studs is at least partly coated by a foil (8) made from an electrically conductive material.

5. Casing according to one of the claims 1 to 4, characterized in that in the vicinity of the casing separating gaps (22) the foil (3) or sheet is preferably given a different thickness and/or is constructed as a bellows (21).

# Fig.1

# Fig.2

# Fig. 3

B     A     C     D

# Fig. 4

E